(19) Europäisches Patentamt
European Patent Office
Office européen des brevets

(11) **EP 2 261 684 B1**

(12) # EUROPEAN PATENT SPECIFICATION

(45) Date of publication and mention
of the grant of the patent:
**08.02.2012 Bulletin 2012/06**

(51) Int Cl.:
***G01R 33/02*** (2006.01)   ***G01R 33/00*** (2006.01)

(21) Application number: **10164576.0**

(22) Date of filing: **01.06.2010**

(54) **Intregrated magnetic triaxial sensor**

Integrierter magnetischer 3D Sensor

Capteur magnétique triaxial intégré

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **03.06.2009 IT MI20090972**

(43) Date of publication of application:
**15.12.2010 Bulletin 2010/50**

(73) Proprietor: **Consiglio Nazionale Delle Ricerche**
**00185 Roma (IT)**

(72) Inventors:
• **Todaro, Maria Teresa**
**73030 Montesano Sal. LE (IT)**
• **Sileo, Leonardo**
**74027 S. Giorgio  TA (IT)**
• **Tasco, Vittorianna**
**73100 Lecce (IT)**
• **De Vittorio, Massimo**
**73100 Lecce (IT)**
• **Cingolani, Roberto**
**73100 Lecce (IT)**
• **Passaseo, Adriana**
**73100 Lecce (IT)**
• **Giordano, Cristian**
**73010 Surbo LE (IT)**

(74) Representative: **Acco, Stefania et al**
**Perani & Partners**
**Piazza San Babila, 5**
**20122 Milano (IT)**

(56) References cited:
WO-A1-96/02848        US-A- 5 672 967
US-A1- 2002 056 202    US-A1- 2008 169 807
US-A1- 2009 058 411

**Description**

The present invention concerns a triaxial magnetic sensor device particularly suitable for detecting the earth's magnetic field and preferably integrated onto a single substrate.

Amongst the numerous applications in which magnetic sensors are used, applications requiring the simultaneous measurement of the three components of the magnetic field are particularly important. Sensor devices capable of measuring the three axial components of the magnetic field vector are generally indicated as triaxial sensors or three-dimensional sensors and are applied to many technological fields. If the sensor device is designed to detect the earth's magnetic field in a predetermined point of space, a high sensitivity is normally required. Devices for detecting the earth's magnetic field are applied, for example, to electronic compasses, or to electron microscopy equipment and in general to systems that are sensitive to the magnetic field, in which it is necessary to cancel out the magnetic field of the earth that can influence the performance of the systems themselves.

In many applications, it has also become an important requirement to obtain a device of small dimension so that it can be easily integrated in portable electronic apparatuses or equipment.

The patent application US 2007/0035294 describes an integrated three-dimensional magnetic sensor device that comprises a first magnetic sensor unit and a second magnetic sensor unit formed in a common plane on a single substrate, and a third magnetic sensor unit formed on a surface that is inclined with respect to the common plane. Each magnetic sensor unit is arranged to detect a direction of the magnetic field. The three directions of the magnetic field detected are mutually perpendicular.

The patent application US 2008/0217288 describes a process for manufacturing a magnetic field sensor device on a substrate that has a plurality of inclined planar sections. The process includes the deposition of a layered structure arranged on each of the inclined sections of the substrate, where the inclined planar sections are oriented so that a direction of the magnetic field in at least one of the three directions defined relative to the substrate can be detected based upon variations induced by the field of the resistance of the structures with magnetic resistant layers.

Triaxial sensor devices are generally designed so that the sensor units, formed for example by a film of metal alloy having an anisotropic magnetic-resistance, are as much as possible aligned to the axial component of the magnetic field to be detected. Alignment errors can lead to measurement errors since the sensor device has a sensitivity, although lower, to the fields perpendicular to the axial components to be detected. In the case of triaxial sensors, the fields perpendicular to the axial components to be detected are generally called cross-axis magnetic fields and we talk about cross-axis effect.

Magnetic sensors that exploit the Hall effect in a semiconductor crystal can be designed so as to display high sensitivity in determining the intensity and the direction of the magnetic field. As it is generally known, the Hall sensor is a transducer that varies its output voltage in response to a variation of the magnetic field. The output voltage, $V_H$, of a Hall sensor, indicated hereafter as Hall voltage, in the case in which the sensor is made from a material containing a single type of charge carrier and is immersed in a homogeneous magnetic field $\vec{B}$, is inversely proportional to the two-dimensional density (sheet density) of charge, $n_{2D}$, if supplied with constant current, I,

$$V_H \propto \frac{B_z\,I}{n_{2D}}, \qquad\qquad (1)$$

in which $B_z$ is the component of the magnetic field along the direction perpendicular to the surface sensitive to the magnetic field. If, on the other hand, the sensor is supplied with constant voltage, the output voltage or Hall voltage, $V_H$, is directly proportional to the mobility of the charge carriers $\mu$,

$$V_H \propto \mu B_z V, \qquad\qquad (2)$$

in which V is the supply voltage. Amongst the main characteristics of a Hall sensor the sensitivity and the resolution should be mentioned. The resolution, that is to say the minimum field that can be detected, improves as the signal/noise ratio increases and as the sensitivity is greater. In general, in order to obtain high sensitivity, a low density of charge carriers and a high mobility of the carriers is necessary. A high sensitivity can be obtained by using semiconductor heterostructures that comprise superimposed layers of semiconducting materials with forbidden bands of different width and selectively doped.

Planar Hall effect sensors in semiconductors III-V, such as AlGaAs/InGaAs/GaAs, have received particular attention, thanks to their high electron mobility combined with a moderate two-dimensional density of the carriers and a low dependency of the sensitivity upon the temperature.

M. Morvic and J. Betko in "Planar effect in Hall sensors made from InP/InGaAs heterostructures", published in Sensors and Actuators A 120 (2005), pages 130-133, studies the planar Hall effect in a Hall sensor prepared from InP/InGaAs heterostructures that contain quantum gaps with two-dimensional electron gas (2DEG) and compares the results with those obtained with a homogeneous Hall sensor GaAs ("bulk"). The authors affirm that the relationship between the maximum planar voltage and the maximum Hall cross voltage is about 50 times lower in the heterostructure with respect to the Hall bulk sensor, for the same magnetic field.

N. Haned and M. Missous in "Nano-tesla magnetic field magnetometry using an InGaAs-AlGaAs-GaAs 2DEG Hall sensor", published in Sensors and Actuators A 102 (2003), pages 216-222, discloses an optimised Hall effect sensor device for measuring weak magnetic fields (100 nT-100 $\mu$T).

A triaxial Hall probe containing horizontal and vertical Hall elements and analogue electronics, is described by D.R. Popovic et al. in "Three-axis Teslameter With Integrated Hall Probe", published in IEEE Transactions on Instrumentation and Measurement, vol. 56, n° 4 (2007), pages 1396-1402.

P. Kejik et al. in "First fully CMOS-integrated 3D Hall probe", published in "proceedings" of the 13th International conference on Solid-State Sensors, Actuators and Microsystems (2005), vol. 1, pages 317-320, describes a 3D Hall probe, in which the detection part is made up of two types of Hall micro-sensors, the horizontal element, measuring the Z component of the magnetic field, and the vertical elements, measuring the "in-plane" components along the directions X and Y.

Over the last decades microfabrication techniques of semiconductor devices have been developed, which have been applied to a variety of applications. Recently, the focus has been directed towards multi-layer "micromachined" structures including thin "strained" layers that can be locally detached from the substrate by means of the selective attack (etching) of underlying sacrificial layers. The structures are manufactured by using the misfit between lattices of the epitaxial layers that bend due to the inner strain.

V. Ya. Prinz in "A new concept in fabricating building blocks for nanoelectronic and nanomechanic devices", published in Microelectronic Engineering 69 (2003), pages 466-475, describes the formation of bent InAs/GaAs bilayers and rolled nanotubes from these "humped" layers and structures exploiting the compressive strain of the InAs/AlAs bi-film.

Patent application US 2002/0056202 relates to a three axis magnetic sensor, the three axis magnetic sensor is so structured that the two axis magnetic sensor and a magnetism detecting element are integrally structured as a hybrid IC. The two axis magnetic sensor is so formed that a base serves as a main member and detects two axial components specified by a plane parallel to the base. The magnetic detecting element detects a component of a direction orthogonal to the plane. As the magnetic detecting element, a magnetic induction element such as a Hall element may be used. The two axis magnetic sensor is structured such that a coil pattern for detecting the two axis components of the magnetic vector is formed on a stacked base.

Patent application WO 96/02848 describes an apparatus for mounting and making electrical connections to solid state sensors, in particular to sensors for the three axis sensing. The apparatus includes a flexible tape circuit comprising tape and conductors and a substrate on which sensors are mounted.

A tri-axial fluxgate magnetometer and housing therefor that includes elements that provide a small-sized, relatively low cost, magnetometer assembly is disclosed in patent US 5,672,967. The magnetometer assembly includes a unitary sensor substrate capable of orthogonally positioning each of the three fluxgate axes and their respective coils and sensors. The assembly positions the unitary substrate on a circuit board that also contains the appropriate harmonic amplifiers, phase detectors, and integrators for signals from each of the three fluxgate axes.

Patent application US 2008/0169807 relates to a magnetic sensor formed in such a way that a thick film formed on a semiconductor substrate is subjected to treatment so as to form a plurality of channels in parallel. Z-axis sensors are realized by a plurality of giant magnetoresistive elements, which are constituted using magneto-sensitive elements formed on slopes of channels and bias magnets for electrically connecting magneto-sensitive elements in series; and X-axis sensors and Y-axis sensors are realized by a plurality of giant magnetoresistive elements, which are arranged at prescribed positions on a planar surface of the thick film. Giant magnetoresistive elements for detecting the intensity of a magnetic field in X-axis, Y-axis, and Z-axis directions are mounted on a single semiconductor substrate, thus realizing a small-size three-axial magnetic sensor.

Patent application US 2009/0058411 relates to a magnetic sensor whose operating layer is made of a group-III nitride semiconductor and a device to which the magnetic sensor is applied. In particular, the disclosed magnetic sensor comprises a GaN layer whose electron concentration is not more than $1 \times 10^{16}/cm^3$; and an AlGaN layer which is formed by $Al_xGa_{1-x}N$ ($0 < x \leq 0.3$), wherein said GaN layer and said AlGaN layer constitute an operating layer having a heterojunction structure. A Hall element is realised, wherein the Hall element comprises the magnetic sensor.

The inventors have noted that triaxial sensor devices the sensor units for detecting a component of the magnetic field of which are made on inclined walls of a common substrate suffer from the cross-axis effect and therefore require relatively complex electronic processing of the electrical output signal.

The inventors have also observed that the triaxial magnetic sensors based on CMOS technology, and in particular upon silicon-based technology, even if made on a single chip, can have low sensitivity and a resolution that is insufficient for detecting the magnetic field of the earth (in the order of 50 $\mu$T) thus requiring particular methods for treating the electric signal that in turn require the provision of relatively complex electronic circuits. Moreover, Si-based devices are generally affected by the thermal drift to a greater extent, mainly due to the intrinsic properties of the material, such as thermal conductivity and the value of the forbidden band and it can therefore be necessary to compensate for the thermal drift of the offset as well as for the thermal drift of the magnetic sensitivity.

One of the objects of the present invention is that of making a triaxial magnetic sensor device that has sensitivity and resolution values such as to be able to accurately detect the earth's magnetic field.

Another object of the present invention is that of providing a triaxial magnetic sensor device that can be made with a manufacturing process that allows a greater miniaturisation, aimed at improving the spatial resolution of the sensor, where by spatial resolution it is meant the minimum distance between two points in space in which it is possible to measure the magnetic field in a distinct manner.

In particular, an object of the present invention is that of making a triaxial magnetic sensor device with electrical connections from each sensor unit of the device to external terminals that are reliable and reproducible.

According to an aspect, the present invention is directed to a magnetic sensor device according to claim 1.

Preferably, the triaxial magnetic sensor device is integrated on a single substrate. The inventors have realised that if the triaxial magnetic sensor device is integrated on a single substrate it is possible to integrate the same both with other devices and with the electronics for treating signals.

Further characteristics and advantages of the invention shall become clearer from the following detailed description given with reference to embodiments of the invention given as non limiting examples and to the attached figures, which are schematic representations not to scale.

Figure 1 is a schematic perspective view of a magnetic sensor device, according to one embodiment of the present invention.

Figure 2a schematically illustrates the cross section of an epitaxial heterostructure with semiconductors comprised in the sensor unit 101, 102 and 103 of figure 1, according to an embodiment of the invention.

Figure 2b schematically illustrates the cross section of an epitaxial heterostructure with semiconductors comprised in the sensor unit 101, 102 and 103 of figure 1, according to a further embodiment of the invention.

Figures from 3 to 11b illustrate in sequence a process for making a triaxial magnetic sensor device, according to an embodiment of the present invention.

Figure 3 is a partial schematic cross-section view illustrating a first step of the process for manufacturing a magnetic sensor device.

Figure 4 is a partial schematic cross-section view illustrating a second step of the manufacturing process.

Figure 5a is an upper planar view illustrating a third step of the manufacturing process.

Figure 5b is a cross-section view along the line A-A of figure 5a.

Figure 5c is the cross-section view of figure 5b, in which the layers forming the heterostructure 13 are illustrated, according to one embodiment of the invention.

Figure 6a is an upper planar view illustrating a fourth step of the manufacturing process.

Figure 6b is a cross-section view along the line B-B of the figure 6a.

Figure 7a is an upper planar view illustrating a fifth step of the manufacturing process.

Figure 7b is a cross-section view along the line C-C of figure 7a.

Figure 8a is a top planar view illustrating a sixth step of the manufacturing process.

Figure 8b is a cross-section view along the line C-C of figure 8a.

Figure 9a is an upper planar view illustrating a seventh step of the manufacturing process.

Figure 9b is a cross-section view along the line C-C of figure 9a.

Figure 10a is a top planar view illustrating an eighth step of the manufacturing process.

Figure 10b is a cross-section view along the line C-C of figure 10a.

Figure 11a is an upper planar view illustrating a ninth step of the manufacturing process.

Figure 11b is a cross-section view along the line C-C of figure 11a.

Figure 12 is a schematic and partial perspective view of a triaxial sensor device, in which the two out-of-plane sensor units are arranged at respective angles $\alpha$ and $\beta$ with respect to the plane (x,y) of the third sensor unit.

Figure 13 is an enlargement of one portion of figure 7b indicated with the broken line F, so as to illustrate the connecting walls of the recess inclined with respect to the surface of the recess itself, according to a preferred embodiment of the invention.

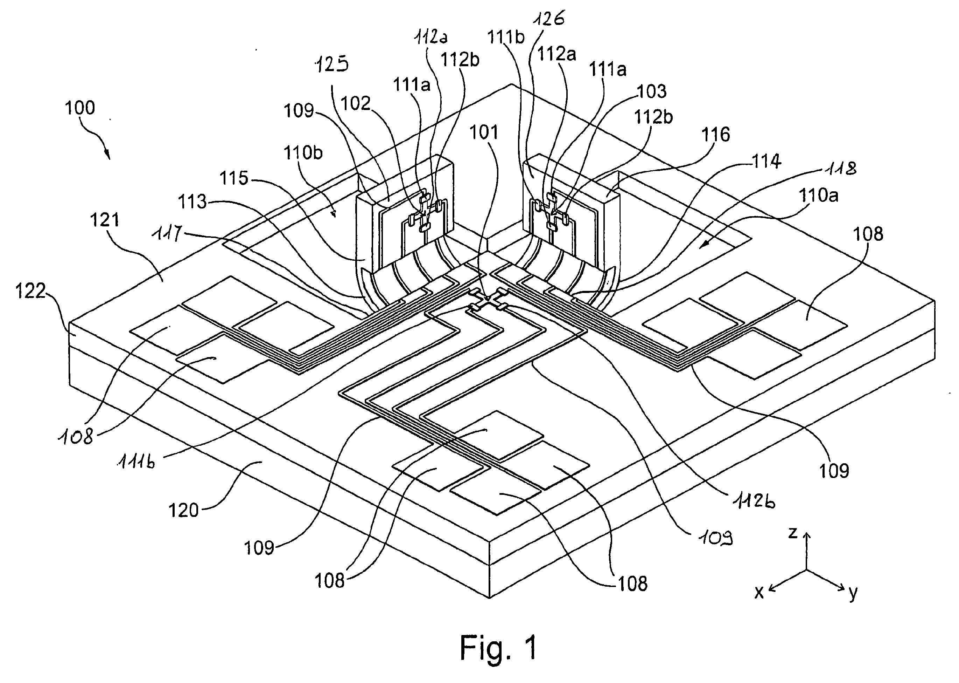

Figure 1 shows a perspective view of the magnetic sensor device, according to an embodiment of the present invention. The triaxial sensor device 100 is made on a substrate 120, preferably a semiconductor substrate. On the substrate 120 a layer or a structure with layers 122 is arranged having an upper surface 121 defining a reference plane (x,y). The reference plane of the upper surface 121 is taken to be substantially parallel to the plane of the upper surface of the substrate 120 and therefore in the rest of the description reference can be made to the reference plane (x,y) of the substrate 120. The terms "upper" and "lower" used in the present description are relative terms that refer to the relative position between two objects and not to their absolute position.

The sensor device comprises three sensor units 101, 102 and 103, each of the sensor units being apt to detect an axial component of the magnetic field. Figure 1 indicates the Cartesian spatial axes (x,y,z) respectively parallel to the three axial components, $B_x$, $B_y$, $B_z$, of the magnetic field, $\vec{B}$, perpendicular to one another. Each sensor unit comprises one magneto-sensitive layer.

The first sensor unit 101 is arranged on the reference plane of the upper surface 121 and is apt to detect the axial component of B perpendicular to such a plane ($B_z$). By the arrangement of a sensor unit on a plane it is meant that the main surface of the magneto-sensitive layer is mainly arranged in that plane. It is to be understood that the magneto-sensitive layer can in turn be made up of a plurality of layers, for example made of different materials and with different thickness, even if in the preferred embodiments the sensor units comprise a single magneto-sensitive layer.

As it shall be described in the following, the preferred embodiments refer to a Hall sensor unit comprising semiconductor epitaxial structures, in which the thickness of the magneto-sensitive layer is so small that it can be assumed that the latter is essentially confined in a plane. In such a case, the main surface of the magneto-sensitive layer is in the plane through which the free charge carriers travel, the free carriers originating the Hall voltage, $V_H$, which is then measured.

The second and the third sensor unit 102 and 103 are arranged in a plane that is different from the plane (x, y) in which the first sensor unit 101 is arranged. With this meaning, the second and the third sensor unit are referred to as "out-of plane" sensor units with respect to the first sensor unit 101. In particular, the second sensor unit 102 is arranged along the plane (x,z), perpendicular to the plane (x,y) of the substrate and it is apt to detect the axial component of $\overline{B}$ perpendicular to such a plane (By). The third sensor unit 103 is arranged along the plane (y,z), perpendicular to the planes (x,y) and (x,z) and it is apt to detect the axial component of $\overline{B}$ perpendicular to such a plane ($B_x$).

In the preferred embodiments, each sensor unit comprises a semiconductor heterostructure comprising a magneto-sensitive layer. Preferably, each sensor unit comprises a semiconductor heterostructure in which, near to a heterointerface between semiconductors made from different materials, a two-dimensional electron gas (2DEG) is formed. The electrons of the 2DEG have a high electron mobility, since they are physically separate from ionised impurities that generated them and are confined in a potential well. Preferably, the heterostructure is an epitaxial structure made from semiconducting material of type III-V.

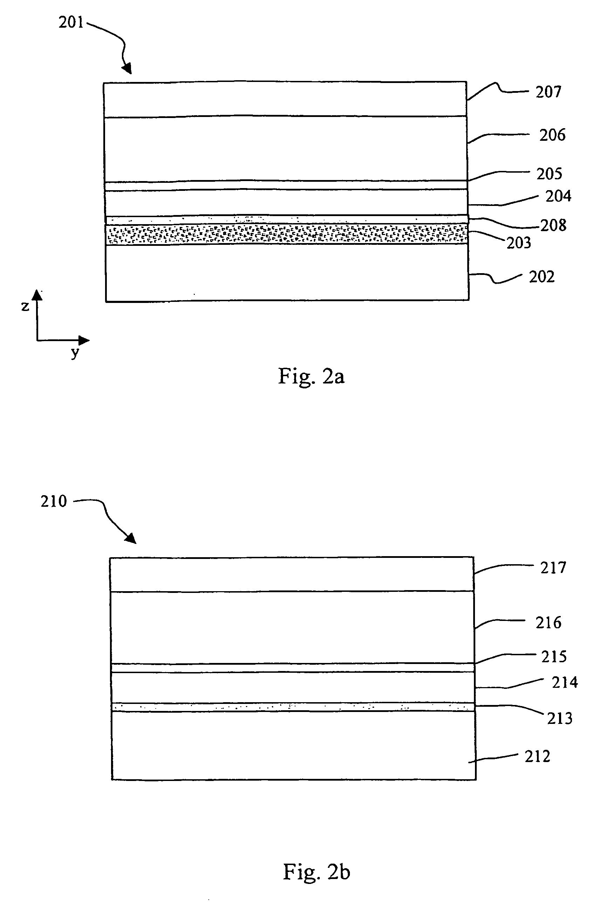

Figures 2a and 2b schematically illustrate the cross-section of two possible semiconducting epitaxial heterostructures III-V that form the active portion of the sensor units 101, 102 and 103 of figure 1. For example, the cross-section illustrated in figures 2a and 2b can be the section in the plane (y,z) of the sensor unit 101. By the expression "active portion" it is meant that the portion of the sensor unit in which the charge carriers arc generated and transported, and in general the portion that influences the carriers, which are then collected by the electrical contacts arranged on the active portion. In particular, the active portion comprises the magneto-sensitive layer in which the Hall effect occurs to a considerable extent. The heterostructures are preferably made by means of epitaxy methods, more preferably by means of the molecular beam epitaxy (MBE).

The heterostructure 201 of figure 2a comprises, in succession along the direction of epitaxial growth, a buffer layer 202 with a narrow band-gap, e.g., non doped GaAs, grown on a substrate or a layer beneath a thin channel layer 203 acting as a channel for the electrons, for example, made in $In_xGa_{(1-x)}As$ with $0<x\leq0.25$; a spacer layer 204 made up of a semiconductor having a wider band gap than the band gap of the buffer layer, for example of $Al_yGa_{(1-y)}As$, not intentionally doped with $0<y\leq0,4$; one barrier layer 206 is of $Al_{(z)}Ga_{(1-z)}As$, evenly doped with dopants of the n type with $0<z\leq0,4$; and finally a "cap" layer 207, for example of GaAs, doped with dopants of the n type or undoped, on which the electrical contacts of the sensor unit can be formed. The quantum well is formed at the interface between the channel layer 203 and the spacer layer 204, on the side of the channel layer. In practice, at the interface of the channel layer 203 and of the spacer layer 204 a very thin layer 208 (in the order of about one atomic plane) of electrons with high horizontal mobility is created forming a two-dimensional electron gas (2DEG), thus making up the electrically active layer of the sensor unit, that is to say the magneto-sensitive layer. The buffer layer 202 is grown on a substrate of the same material, for example semi-insulating GaAs and has the function of offering a semiconducting epitaxial layer for growing the subsequent layers that form the heterostructure. The spacer layer 204 has the function of increasing the physical separation between the electrons of the 2DEG and the ionised impurities that made them available. The cap layer 207 has the function of protecting the underlying barrier layer 206 and, if suitably doped, can promote the formation of ohmic contacts due to the deposition of metal contacts.

In a different embodiments, the barrier layer 206 is not intentionally doped and the doping impurities of the n type are confined, during the growth, on a single atomic plane or on a few atomic planes. In particular, an upper portion of thickness reduced by the spacer layer 204, in the direction of growth of the layers, near to the interface between the spacer layer 204 and the barrier layer 206, is doped so as to form a very thin box-shaped profile, the so called "delta doping", 205. For example, the layer 205 with delta doping is strongly doped with dopants of the n type and has a thickness in the order of an atomic plane. In this case, the electrons forming the 2DEG derive from the doping impurities of the delta doping layer 205.

The barrier layer, when uniformly doped, or the "delta doping" layer when the barrier layer is not intentionally doped, is doped, for example, with an element from the IV group of the periodic table (e.g., Si or Ge).

The channel layer 203 is "pseudomorphic" with respect to the buffer layer 202 on which it is grown and has a lattice constant that is greater than that of the buffer layer, so as to allow differences of forbidden gaps greater than what is possible without the pseudomorphism. The thickness of the channel layer 203 is typically of 100-300 Å.

Figure 2b illustrates a further possible heterostructure suitable for the purpose of the present invention. The greatest difference with the heterostructure described with reference to the figure 2a is the fact that there is no channel layer between the buffer layer and the spacer layer. In particular the heterostructure 210 comprises, along the growth direction (z axis): a buffer layer 212 not intentionally doped (GaAs); a spacer layer 214 not intentionally doped ($Al_yGa_{(1-y)}As$), a barrier layer 216 comprising a "delta doping" layer 215 doped n ($Al_zGa_{(1-z)}As$), and a undoped cap layer 207 (GaAs) or heavily doped with n type dopants to promote the formation of ohmic contacts.

The layer 2DEG 213 is formed at the interface between the spacer layer 214 and the buffer layer 212, on the side of the buffer layer.

It should be understood that the heterostructures of figures 2a and 2b can be based on InP and on ternary alloys based on InP. For example, the buffer layer 202 is made from undoped InP; the channel layer 203 is of $In_hGa_{(1-h)}As$ (e.g., h=0.53); the spacer layer 204 is of non doped $In_kAl_{(1-k)}As$ (k=0.52); the barrier layer 206 is of $In_kAl_{(1-k)}As$ uniformly n-doped in its thickness or in a "delta doping" layer 205; and the cap layer is of InP.

The number of the charge carriers in the quantum well (2DEG) is given by the sheet charge density, $n_{2D}$. Therefore, from the equation (1), it is possible to select parameters, such as the thickness of the materials forming the heterostructure, their composition and the amount of doping, so as to optimise the sensitivity of the sensor unit at the axial component of the detected magnetic field. The electron mobility, $\mu$, in the quantum well structure is typically very high, for example equal to $7000 \div 7500$ $cm^2/Vs$. Therefore, with reference also to the equation (2), by suitably selecting the parameters of the heterostructure, it is possible to make a sensor unit with high sensitivity.

Preferably, the sheet density of the carriers integrated on the thickness of the magneto-sensitive layer, $n_{2D}$, varies from $5x10^{11}$ to $1x10^{12}$ $cm^{-2}$. In general, the thicknesses and the compositions of the layers of the heterostructure, as well as the amount of doping especially of the barrier layer (with or without delta doping) control the amount of charge trapped in the 2DEG.

Optionally, in the structure of the type illustrated in figure 2a, the buffer layer 202 comprises a super-lattice at the interface with the substrate or the underlying layers that are not part of the heterostructure, for example AlGaAs/GaAs (not shown).

Optionally, in the structure of the type illustrated in figure 2b, the buffer layer 212 comprises a super-lattice at the interface with the underlying layers, for example AlGaAs/GaAs (not shown).

Since the layer 2DEG 208 (213) of the heterostructure 201 (210) produces the charge carriers with high mobility that create the Hall voltage, according to the relationship (1), such a layer is the electrically active layer that forms the magneto-sensitive layer of the sensor unit.

The sensor units comprise heterostructures in their active portion such as those illustrated in the figures 2a and 2b that are indicated in the present description as HEMT type structures ("High Electron Mobility Transistor") since they are structures apt to generate electrons with high mobility by using a heterojunction. In the case the presence of a channel layer is foreseen (figure 2a), which is arranged on the lower layer forming the heterojunction in a state of compression or tension (pseudomorphic), it is often referred to as a pHEMT type structure, i.e., pseudomorphic HEMT, which is a particular type of the HEMT type structures.

Again with reference to figure 1, preferably, the area of the main surface of each sensor unit in the plane in which the magneto-sensitive layer is arranged is cross-shaped, more preferably having the shape of a Greek cross with equal sides. In the embodiment of figure 1, each sensor unit comprises a mesa structure that rises up with a patterned structure with respect to the underlying layers on which it is arranged. In a preferred embodiment, further detailed hereafter, the mesa structure can be of the "shallow" type, if it is formed by the layers of the heterostructure arranged above the magneto-sensitive layer of the sensor unit. In this configuration, it is preferable that the mesa structure comprises the spacer layer (204, 214) in almost its entire thickness. In particular, a residual thickness of the spacer layer, preferably selected within the range of about 3 nm to 20 nm, the magneto-sensitive layer on which the spacer layer is arranged and the layers of the heterostructure beneath the magneto/sensitive layer are not mesa patterned, as on the other hand the vertical portion of the heterostructure above them is patterned along the direction of growth of the layers.

On the semiconductor heterostructure that makes up the active part of each sensor unit 101, 102, 103 two pairs of electric terminals are formed, that is to say a pair of power power supply terminals 111a and 112a, opposite one another, and a pair of Hall output voltage terminals, $V_H$, 111b and 112b, indicated also as Hall terminals and opposite one another.

Each electric terminal of the sensor unit is electrically connected to a metal pad 108 by means of an electrically conductive strip 109. The pads 108 can be used for example for the electrical connection external to the sensor device, for example for the connection with an integrated circuit containing the electronics or with a package enclosing the sensor device. In the embodiment illustrated, each sensor unit is connected to four pads 108, one for each terminal.

It should be understood that the area of the main surface of the sensor units can have geometrical shapes different from the cross shape, amongst which, for example, a rectangular, square, or circular shape. With different geometrical shapes it is possible to consider using a power supply terminal and a Hall terminal, or a plurality of Hall terminals. In some embodiments, a cross shape is preferable so as to reduce the short circuit effects between electrical terminals.

Preferably, the three sensor units have the same structure, and in particular they comprise an identical heterostructure.

The sensor units 102 and 103 are arranged on respective cantilever structures 1 15 and 116 that are located at a certain elevation angle, $\vartheta$, with respect to the substrate 120, i.e., to the main surface 121 of the "in-plane" sensor unit, or reference plane (x,y). The cantilever structures are raised with respect to the substrate 120 by means of respective hinge structures 113 and 114 that support them in the raised position. On the main surfaces 125 and 126 of the respective cantilever structures 115 and 116 the respective sensor units 102 and 103 are formed.

The cantilever structures 115 and 116 are partially surrounded, in the substrate plane, by respective recesses 110b and 110a etched from the main surface 121 in the reference plane. The depth of the recesses with respect to the reference plane is greater than the thickness of the cantilever structures and preferably uncovers the substrate 120, by removing the layer or plurality of layers 122.

Each one of the two hinge structures has an upper surface arranged on the side of the main surface of the respective cantilever structure and has a lower surface, opposite to the upper surface, that at least partially faces the respective recess.

The hinge structures 113 and 114 are curved with respect to the substrate 120 and have a thickness that is smaller than the thickness of the respective cantilever structures 115 and 116. The main upper surface of the cantilever structure on which the "out-of-plane" sensor unit is formed joins with the upper surface of the respective hinge structure by means of a connecting wall. It is noted that, in order to create the electrical connection with a terminal outside the cantilever structure and outside the hinge structure supporting the latter, the electrically conductive strips 109 must extend from the terminals of an out-of-plane sensor unit to the one or more external terminals passing along the main surface of the respective cantilever structure and along the connecting wall to then continue along the upper surface of the respective hinge structure. Moreover, since the hinge structure is arranged recessed with respect to the reference plane 121, there is a further connecting wall (not visible in figure 1) that the conductive strips 109 must pass through to reach the main surface 121 of the sensor device where the external terminals, for example the pads 108, are typically positioned. The connecting wall between the upper surface of the hinge structures 113 and 114 and the reference surface 121 extends along a respective connecting line 117 and 118 defined on the main reference surface 121.

The inventors have observed that it is important to ensure a continuity of the electrical connection between the terminals of the sensor unit and the regions of the device used for the external electrical connection. The inventors have also observed that, especially in the case of electrical connections made with thin metal strips, the making of electrical connections with uneven thickness or that are not continuous along vertical or almost vertical walls can negatively affect the electrical conduction, in particular due to the presence of high electrical resistance or to open circuits in the areas of discontinuity of the strips.

Preferably, each of the first, the second and the third sensor units of the magnetic sensor device comprises at least one respective pair of electrical terminals of sensor units (111a, 112a, 111b, 112b, in the embodiment of figure 1), each electric terminal of sensor units being electrically connected to an outer electrical contact (e.g. pad 108) by means of an electrically conductive strip. Preferably, the outer electrical contact is on the main surface on which the first sensor unit is arranged. In some preferred embodiments, the electrically conductive strip of the second sensor unit, from the respective electrical terminal of the second sensor unit, passes at least one portion of the main surface of the first cantilever structure, the first hinge structure and at least one portion of the first main surface. The conductive strip of the third sensor unit, from the respective electrical terminal of the third sensor unit, passes at least one portion of the third main surface of the second cantilever structure, the second hinge structure and at least one portion of the first main surface.

In the preferred embodiments, the two cantilever structures 115 and 116 have the same thickness, just as the two hinge structures 113 and 114 also have the same thickness, simplifying in this way the manufacturing process of the integrated device. For example, the thickness of each hinge structure is of between about 250 nm and 300 nm and that of each cantilever structure is of between about 0.8 and 1.2 $\mu$m.

The hinge structures 113 and 114 each comprise a "strained" structure comprising a plurality of epitaxial films (not shown in the figures) with different lattice constant so as to generate a state of tension (strain) in the structure during the growth of the film, due to the elongation and/or the compression of at least one film of the plurality of films. In the preferred embodiments, the hinge structures 113 and 114 are formed by a strained structure made up of a pair of epitaxial films with different lattice constant, as described later on in the description in greater detail. Each of the cantilever structures 115 and 116 comprises a heterostructure of the HEMT type grown on a strained structure, where the strained structure of the cantilever structure is identical to the strained structure that forms the respective hinge structure. In this way, the lower surface of each cantilever structure, the lower surface being opposite to the main surface on which the sensor units are arranged, joins with the lower surface of the respective hinge structure in a continuous manner.

In the embodiment of figure 1, the main surface of the cantilever structures 115 and 116 on which the sensor units 102 and 103 are respectively arranged, is located perpendicular to the substrate 120. In other words, the elevation angle, 9, of both the cantilever structures is of about 90˚.

Figures from 3 to 11b schematically illustrate the manufacturing steps of a triaxial magnetic sensor device, according to an embodiment of the invention.

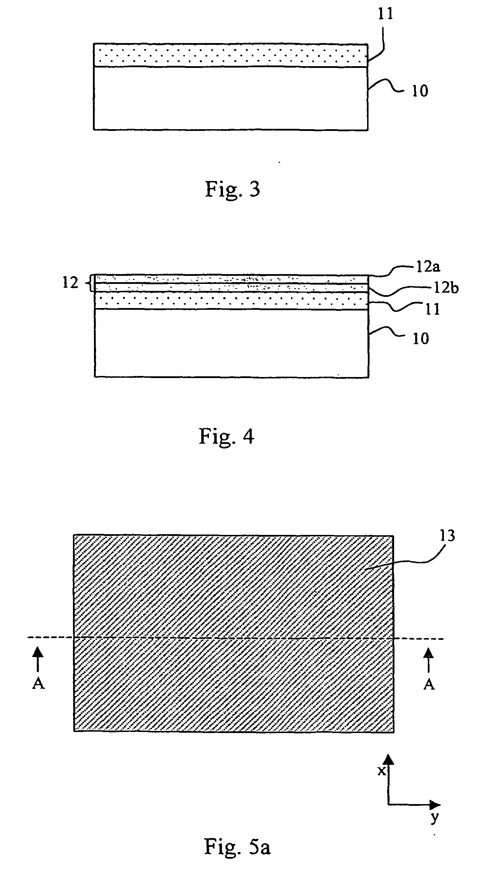

Figure 3 is a partial schematic cross-sectional view illustrating a first step of the manufacturing process of a magnetic sensor, in which a sacrificial layer 11 is deposited on a substrate 10. In a preferred embodiment, the substrate is a standard GaAs or InP wafer.

With reference to figure 4, an (elastically deformable) "strained" structure 12 is formed on the sacrificial layer 11, said structure comprising a plurality of films with different lattice constant generating a strain state in the structure, due to the elongation and/or to the compression of at least one film of the plurality of films. Preferably, the sacrificial layer 11 and the structure 12 are made from semiconducting materials epitaxially grown on the substrate 10, in particular by means of Molecular Beam Epitaxy (MBE). The strained structure 12 comprises a succession of at least two films alternately compressed and elongated. The number of films alternately compressed and elongated comprised in the strained structure depends on the materials used and on the thickness of the films.

In one embodiment, illustrated in figure 4, the strained structure 12 is made up of two epitaxial films: one first film 12b grown on the sacrificial layer 11 and having a first lattice constant and a second film 12a arranged on the first film 12b and having a second lattice constant smaller than the first lattice constant. Due to the difference between the lattice constants of the two films forming the strained structure, the second epitaxial film 12a grown on the first film deforms so as to adapt to the crystal lattice of the first film, thus being under tension, whereas the first epitaxial film 12b is under compression.

The sacrificial layer 11 is made with a material that can be selectively etched with respect to the strained layer, and preferably, with respect to the substrate beneath, by means of known wet-chemical etching techniques, as described in greater detail in the following.

In some embodiments, the sacrificial layer 11 is made from AlAs or from a AlGaAs/AlAs digital alloy and the strained structure 12 is made up of a pair of films (bi-film) made from $In_xGa_{(1-x)}As$/GaAs (0<x≤0.25), where the film $In_xGa_{(1-x)}As$ (layer 12b) is directly grown on the AlAs layer (layer 11).

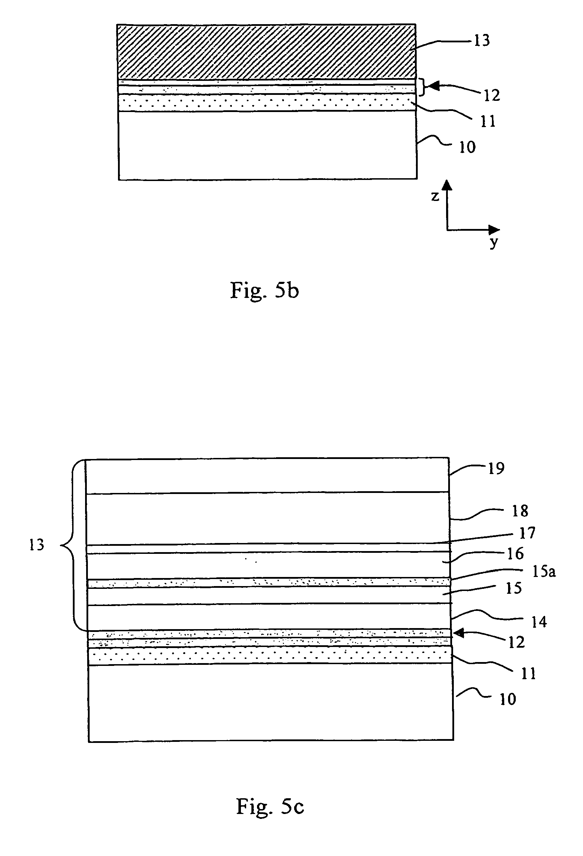

In a subsequent step, illustrated in the figures 5a and 5b, on the elastically deformed layer 12, a heterostructure 13 is formed that makes up the active portion of the sensor unit.

In the preferred embodiments, each of the three sensor units comprises an HEMT type heterostructure, based upon binary and/or ternary alloys made of semiconducting material of the III-V type, for example a structure of the type illustrated in figure 2a or in figure 2b. In figure 5c, the semiconducting layers forming the heterostructure 13 of figure 5b are schematically shown, according to a preferred embodiment. The layers that make up the structure 13 are epitaxially grown, preferably by MBE, and form a pHEMT type structure. In particular, a buffer layer 14, for example made up of GaAs or GaAs for a part of the thickness and of a AlGaAs/GaAs super-lattice for the remaining part, is grown on the strained structure 12 with a thickness sufficient to obtain a layer with good crystallinity for growing the subsequent layers free of strain. Then the following are grown in sequence: a channel layer 15 (InGaAs), a spacer layer 16 (AlGaAs), a doped barrier layer 18 (AlGaAs) and a (GaAs) "cap" layer 19. Optionally, the barrier layer 18 can be not doped and comprises a layer with a very thin thickness (about one atomic layer) in the proximity of the interface with the spacer layer with a box-shaped doping profile so as to form a "delta doping" profile, 17 (AlCaAs:Si). Figure 5c indicates the magneto-sensitive layer 2DEG 15a, that is formed at the interface between the channel layer 15 and the spacer layer 16.

In the case in which the film 12a of the strained structure 12 is made from epitaxial GaAs, the film 12a and the buffer layer 14 can be grown as a single layer on the lower film 12b of the strained structure.

As an example, the overall thickness of the epitaxial heterostructure 13 is of from 1 $\mu$m to 1.5 $\mu$m.

It should be understood that by modifying the different parameters of the heterostructure, like the thicknesses of the layers, the amount of doping and the concentration of the ternary alloys in the barrier and spacer layers and (if present) in the channel layer, it is possible to vary the combination of the values of $\mu$ and of $n_{2D}$ according to the specific application, determining the performances of the sensor, such as the detection sensitivity and/or the response time of the device, as well as its behaviour to temperature variations.

Preferably, the buffer layer 14 has a thickness ranged between 700 nm and 950 nm, for example of 900 nm, so as to move the magneto-sensitive layer containing 2DEG away from the parasite quantum well that could form at the strained structure 12. Moreover, a relatively great thickness of the buffer layer can make the heterostructure more rigid so as to prevent the cantilever structure from bending instead of positioning the sensor units at a certain elevation angle $\vartheta$ with respect to the plane (x,y), as described in a subsequent step of the process.

The layers making up the active portions of the sensor units, can be deposited on the whole underlying substrate, or at least on the whole surface area on which the strained structure 12 is deposited. In this way, the heterostructures that will make up the sensor units can be simultaneously grown, with a single process.

After the deposition of the heterostructures, the sensor units are defined through lithographic methods defining the surface area of the units, and thus the area of the surface for detecting the magnetic field, and chemical or chemical-physical etching methods, *per se* known, to define the geometrical structure of the active portions of the sensor unit and isolate them from one another on the magnetic sensor device.

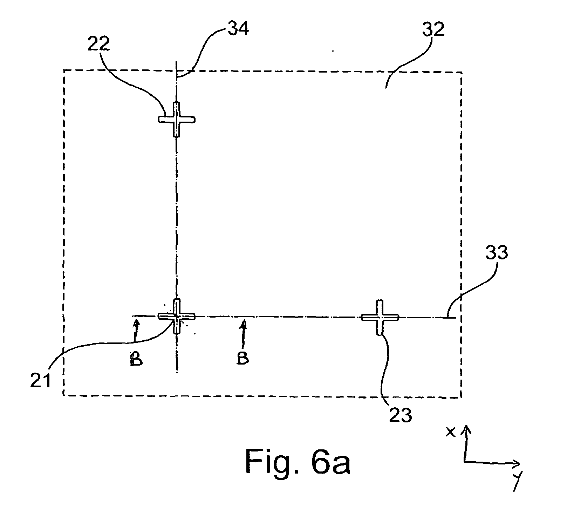

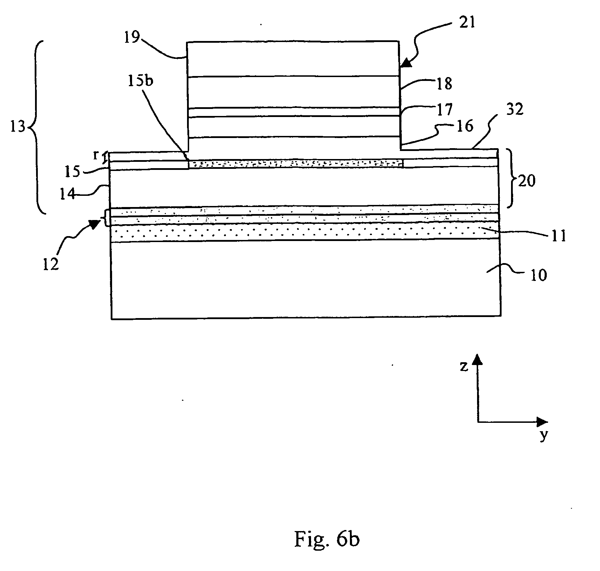

In particular, after having defined three cross-shaped areas by means of optical lithography, a wet-chemical etching, for example consisting of a solution in H2O containing citric acid ($C_6H_8O_7$) and oxygenated water ($H_2O_2$), (for example, in the proportions 16g $C_6H_8O_7$,: 16g$H_2O$ DI and 1ml $H_2O_2$), removes at least one vertical portion of the heterostructures everywhere except for at said areas, thus forming raised "mesa" structures 21, 22 and 23, illustrated in a planar view in figure 6a and in cross-section along the line B-B in figure 6b. It should be understood that the chemical etching simultaneously creates three raised structures relative to the three sensor units, which have active portions that are isolated from one another.

The inventors have realised that, although the removal by chemical etching can in principle continue up to the layer 12, a deep etching can have drawbacks, like the loss of rigidity of the cantilever structure comprising the mesa structure with consequent bending or even rolling of the cantilever structure. Moreover, deep etching can lead to the formation of steps that are too high for an optimal realisation of the subsequent manufacturing steps, and in particular for the manufacture of the electrical conduction lines that connect the terminals of the sensor unit to the regions of the sensor device used for the external electrical connection.

The inventors hove noted that deep etching can limit the minimum surface size of the mesa structures, below which the complete surface charge depletion takes place, due to the surface charge depletion at the vertical walls of the mesa. In some preferred embodiments, the mesa structure of each sensor unit at least partially comprises the layers of the heterostructure above the magneto-sensitive layer. In the embodiment of figure 6b, the removal through etching along the axis z is stopped at a depth located along the axis z near to the interface between the spacer layer 16 and the 2DEG. Preferably, the stopping of the etching occurs at a thickness in the spacer layer 16 selected so that the stopping point of the etching is sufficiently close to the channel layer 15 to make it possible to deplete the charge due to the surface layers and to produce the isolation of the mesa structures. For example, the stopping of the etching occurs in the spacer layer at about 10 nm from the interface with the channel layer 15. In this case, the channel layer is not etched, but due to the etched groove, a magneto-sensitive layer 2DEG 15b is formed present only at the non-etched region. A structure of this type is indicated in the present context as mesa of the surface or "shallow" type and has the advantage of further improving the mobility of the charge carriers in 2DEG since it is not affected by the surface depletion of charge at the vertical walls of the mesa structures. Advantageously, since a mesa structure of "shallow" type preserves the charge on the vertical walls, this solution makes a greater miniaturisation of the mesa structure and therefore of the magnetic sensor device possible. More in general, the heterostructure of each sensor unit comprises a plurality of layers, a first layer of said plurality being a magneto-sensitive layer and a second layer being an upper contact layer (e.g., cap layer) arranged on the remaining layers of the plurality, where the heterostructure includes a mesa structure that extends vertically (i.e. with respect to the substantial surface arrangement of each layer of the plurality) for a first vertical portion of the heterostructure, in which said first vertical portion extends from the contact layer to a predetermined depth located, in the vertical direction, in the proximity of the magneto-sensitive layer so as to define a residual thickness, r, defined between the upper interface of the magneto-sensitive layer and the surface of a second vertical portion of the heterostructure beneath the first vertical portion, which corresponds to the main surface on which the sensor unit is formed. Preferably, the residual thickness, r, is of about 3 to about 20 nm.

In the non-etched regions, different from the mesa structures, the spacer layer 16 present in a residual thickness, r, on the magneto-sensitive layer remains exposed on the surface area. The second vertical portion, that is to say along the direction of growth of the layers of the non-etched heterostructure is indicated in figure 6b with reference numeral 20 and the surface of such a non-etched epitaxial portion (the main surface) is indicated with reference numeral 32.

In some embodiments, the chemical etching for forming the mesa structures is carried out with wet-etching by using a solution of $H_2O$ containing $H_2O_2$, in combination with an acid (sulphuric, nitric, hydrochloric or citric) or a base (sodium hydroxide).

With reference to figure 6a, preferably, the centres of the mesa structures 21 and 22 are arranged along an axis 34 arranged at 90° with respect to the axis 33 passing through the centres of the mesa structures 22 and 23.

In a different embodiment, the removal through etching continues through the channel layer 15 along the vertical axis (along the direction of growth) to the interface between the channel layer 15 and the buffer layer 14. In the case of mesa structures comprising the channel layer, reference will be made in the present context to deep type mesa structures.

In a still further embodiment, the removal by etching continues as well as at the interface between the channel layer 15 and the buffer layer 14, inside the buffer layer, but stopping the removal near to the interface (embodiments not shown in the figures), preferably within 30 nm from it, inside the buffer layer, more preferably within 20 nm from it. In some preferred embodiments the buffer layer 14 has a relatively high thickness, preferably ranged between 700 nm and 950 nm and therefore the removal of a very small thickness of the buffer layer with respect to the overall thickness prevents bending of the cantilever structures, that will be made in the subsequent steps of the process.

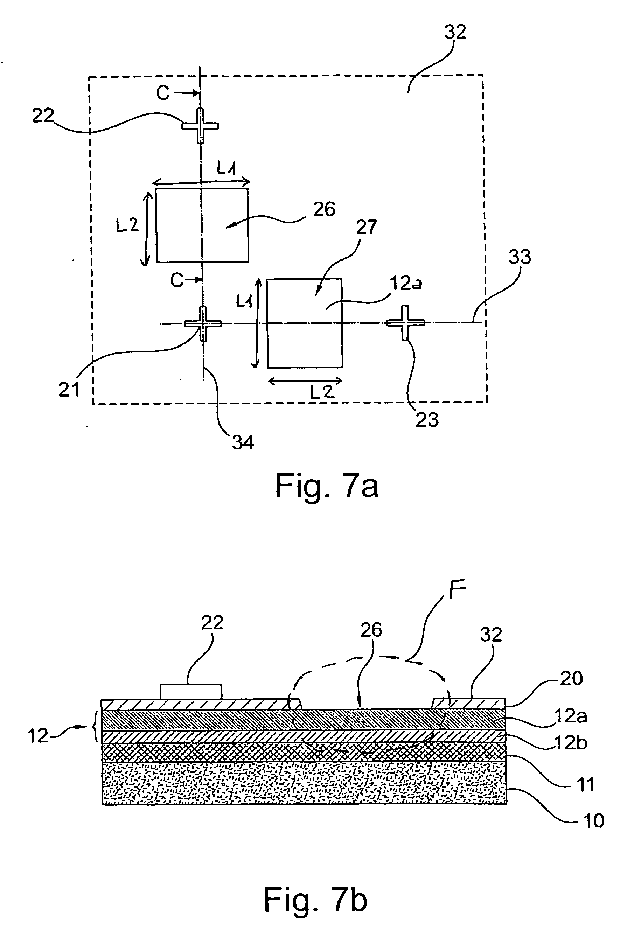

Figures 7a and 7b, representing a portion of the cross-section along the line 34 of figure 7a (section C-C), represent the step subsequent to the formation of the mesa structures 21, 22 and 23, in which the surface areas of the hinge structures are defined, that is to say the regions that will act as a hinge for the structures comprising the sensor units and that shall bend thus arranging the sensor units at a certain elevation angle 9 with respect to the plane (x,y) of the substrate. The surface areas of the hinge structures are defined forming recesses, in the proximity of the mesa structures 22 and 23, uncovering the strained structure 12 and in particular a surface of the layer 12a. In order to define the surface areas of the hinge structures, first recesses 26 and 27 are defined, for example through photolithography and etching.

In one embodiment, the etching is stopped when the surface of the strained structure 12 is reached. In practice, since the buffer layer of the heterostructure and the upper layer (12a) of the strained structure 12 can be grown as a single epitaxial layer (e.g., of GaAs), said layer is eroded until a residual thickness acting as the layer 12a is left over. In one embodiment, the thickness of the layer 12a is ranged between 40 nm and 300 nm. In one embodiment, the layer 12b is made in $In_xGa_{(1-x)}As$ with x variable from 0.1 to 0.3 and has a thickness of between 3 nm and 30 nm.

Preferably, the recesses 26 and 27 have a rectangular geometry along a plane parallel to the plane (x,y) and are preferably arranged with the two sides substantially parallel to the arms of the cross of the mesa structure. The recesses 26 and 27 are positioned adjacent to the respective mesa structures 22 and 23 and have a width L1 and a length L2, the width L1 being at least equal to the size of the mesa structure along the direction defined by the same width and preferably greater so as to be able to arrange the electrical connections from the respective sensor unit on their surface. In one embodiment, the recesses 26 and 27 are defined with equal surface area.

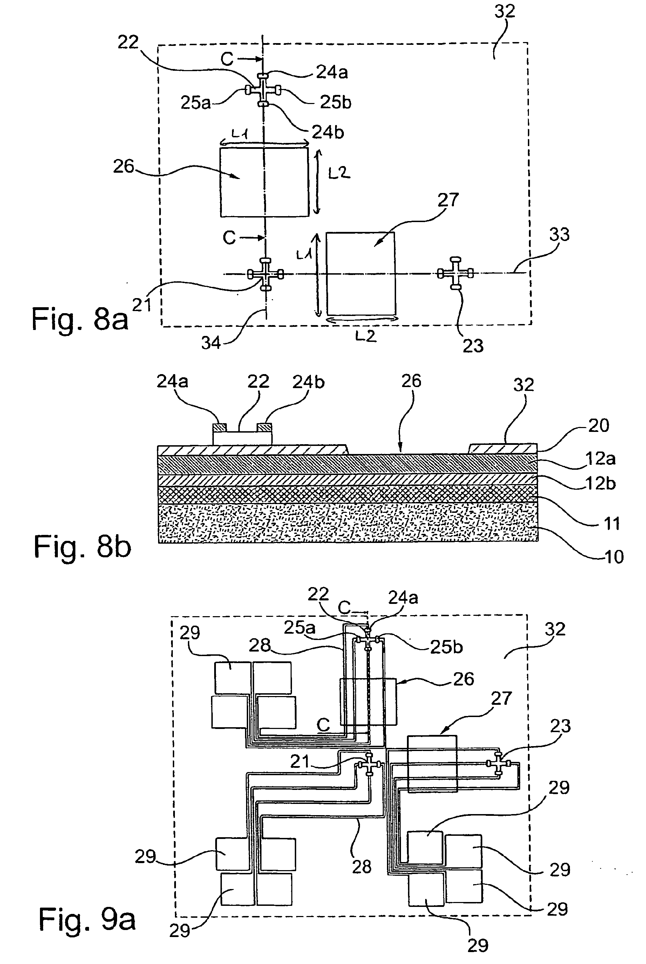

After the formation of the areas for forming the hinge regions, the electrical terminals of the sensor units are formed, in particular a pair of power supply terminals 24a and 24b, opposite one another, and a pair of Hall output voltage terminals, $V_H$, 25a e 25b, opposite one another (figure 8a for the planar view and figure 8b for the cross-section C-C of figure 8a). The electrical terminals can be made in Au or in metal alloy, such as GeAu/Ni/Au, for example through the so-called, per se known, "lift-off" technique, in which a lithographic process that leaves only the surface regions on which metal is wanted uncovered by the photoresist, is then followed by the deposition of the metal itself, for example through evaporation, and finally by the removal of the photoresist through the use of an appropriate solvent, according to known techniques. In order to obtain ohmic contacts, it is preferable to subject the metal contacts, once deposited, to rapid thermal annealing (RTA) at relatively high temperatures , e.g., 400-460˚C.

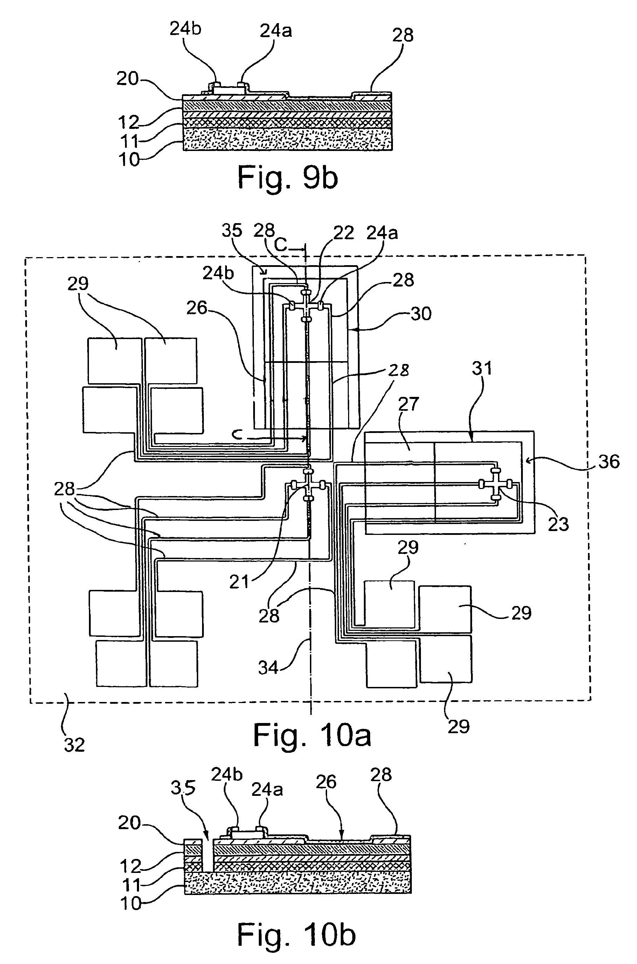

In a subsequent step, illustrated in figures 9a and 9b, the conductive strips 28 that connect the terminals of each sensor unit to conductive pads 29 are made, for example made from metal or metal alloy. The deposition of the conductive strips and of the pads can be obtained through the lift-off method the metal deposition, which can occur by sputtering deposition. The pads can be used for example for connecting with an integrated circuit containing the control electronics or with a package enclosing the sensor device. In the embodiments illustrated in the figures, each terminal of a sensor unit is connected to a respective pad.

As indicated in the figures 9a and 9b, in order to make an electrical connection between the terminals of the out-of-plane sensor units 22 and 23 and the contact regions external with respect to the regions in which the sensor units are formed, the electrically conductive strips 28 must pass through respective recesses 26 and 27 along their length L2 and therefore need to be deposited along both the upper surface of the recesses and the side walls that define it and join it to the upper surface 32. The inventors have realised that the step of forming the metal strips is particularly critical since a non continuous or non uniform deposition of the strips causes high resistance peaks at the discontinuities. The inventors have also experimentally observed that making the metal strips on recesses with vertical or semi-vertical connecting walls with angles near to 90˚ compromises the operation of the out-of-plane sensor units and therefore that of the triaxial sensor device, and in particular leads to difficulty in applying a signal and receiving a response from the sensor units. The problem of the discontinuities of the metal strips is more relevant in the case of relatively thin metal strips, for example with thickness not greater than 20 nm, in this way limiting the scalability of the sensor device.

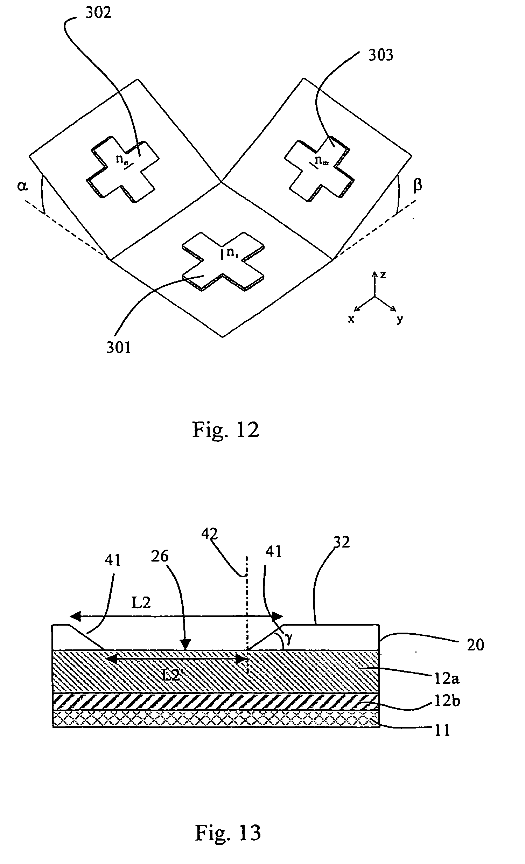

It has been found that, in one aspect according to some preferred embodiments of the invention, connecting walls inclined by a predetermined angle with respect to the surface of the recess and defining the recesses that define the hinge structures, at least along the direction transverse to the path of the conductive strips along the recess, make it possible to obtain the formation of electrical conduction lines that are even and continuous, even with relatively small thicknesses, for example not greater than about 60 nm. The use of recesses with inclined walls has a further advantage in the case of miniaturisation of the sensor device when the LENGTH L2 of the hinge, that, as indicated in the relationship (3) outlined hereafter, is related to the radius of curvature $\rho$ of the strained structure, it becomes comparable with the vertical height of the heterostructure. In such a case, vertical connecting walls of the recesses could limit the elevation angle of the cantilever structures since such walls would come into contact with one another fol lowing bending of the hinge. For example, for a heterostructure with a thickness of from 1 $\mu$m, the strained structure with $\rho$=1 $\mu$m can be designed so as to ensure an elevation angle of 90° only for lengths of the recesses L2≥1.5 $\mu$m. Figure 13 is an enlargement of a portion of figure 7b, indicated with a circle F in a broken line, and therefore represents a step of the process before the formation of the electrical connections. The recess 26 has side walls inclined by an angle $\gamma$ with respect to its main surface or, defined in an equivalent manner, by an angle (90°-$\gamma$) with respect to the axis 42 perpendicular to the main surface of the recess. The recess 26 therefore has a truncated pyramid shape with a length L2 on the plane of the upper surface 32 from which the recess is etched and a length L2'<L2 on the main surface of the recess.

Preferably the inclination angle $\gamma$ is of from 10° to 70°. In a particularly preferred embodiment, the angle $\gamma$ is of about 45°. The inventors have noted that angles of the recess inclined by about 45° allows reduction of the surface dimensions of the cantilever structures to 4 $\mu$m x 4 $\mu$m, inside which a (respective) mesa structure can be formed with surface dimensions of 500 nm x 500 nm, thus obtaining the miniaturisation of the out-of-plane sensor unit and consequently of the entire magnetic sensor device.

Preferably, for forming the recesses an anisotropic wet etching of the epitaxial layers is used to produce recesses with side walls inclined by an angle $\gamma$ with respect to the main surface of the recess. For example, a solution $H_2SO_4/H_2O_2/H_2O$ is used in the proportions 8:1:100 to produce walls inclined by about 15° through the epitaxial layers of the heterostructure AlGaAs/InGaAs/GaAs.

The variation of the angle of the inclined walls of the recess can be obtained for example by varying the concentration of the solution $H_2SO_4/H_2O_2/H_2O$, as described for example by S. Iida e K. Ito in "Selective Etching of Gallium Arsenide Crystals in H2SO4-H2O2-H2O System", published in Journal of Electrochemical Society, volume 118-5 (1971), page 768.

Even if figure 13 shows a detail of the recess 26, it should be understood that both recesses 26 and 27 that uncover the strained structure 12 preferably have inclined connecting walls. With again reference to figures 9a and 9b, in the illustrated embodiment the conductive strips 28 go down along the side walls of the respective recesses 26 and 27 arranged in the main plane defined by the surface 32 transverse and in particular perpendicular to the direction of the path of the conductive strips. In practice, common techniques for making the recesses create inclined walls along all the side walls of the recesses.

Preferably, the inclination angle of the connecting wall between the upper surface of the hinge structure and the main surface of each cantilever structure is equal to the inclination angle of the connecting wall between the main surface of the device substantially parallel to the substrate (e.g. surface 32 in figure 8a) and the upper surface of the hinge structure. This characteristic can be for example obtained through anisotropic wet etching as described above.

The inventors have observed that conductive strips that are too thick can substantially modify the strain of the strained structure 12 and therefore the elasticity of the hinge structures formed in the recesses 26 and 27 and consequently influence the raising of the cantilevers on which the out-of-plane sensor unit are arranged, negatively. Preferably, the conductive strips 28 have a thickness which is not greater than about 60 nm, more preferably not greater than about 40 nm. In order to obtain an ohmic contact, it is preferable for the conductive strips to have a thickness that is not less than 20 nm. In a preferred embodiment, the thickness of the metal strips ranges between 20 and 60 nm. The width of the conductive strips can be ranged between 50 nm and 50 $\mu$m, depending on the dimensions of the device as well, for example on the dimensions of the hinge structure. It should be noted that in general the thickness of the conductive strips affects the elasticity of the hinge structure in a prevalent manner with respect to their width.

Even if in the previous description we have referred to two distinct process steps for the deposition of the electrical terminals and for the deposition of the electrical connections, the present invention alternatively foresees a single process step in which the electrical terminals of the sensor unit and the metallizations for the electrical connections are made simultaneously, for example through the lift-off method.

Moreover, in the case in which the process step of forming the electrical terminals is distinct from the step of forming the electrical connections at the pads, the deposition of the electrical terminals of the sensor units, can occur after or before the step of forming recesses to define the hinge regions.

Once the electrical connections have been made, the manufacture of the sensor units can be considered complete. The subsequent steps of the process are needed to make the suspended structures that arrange two of the three sensor units of the substrate out-of-plane.

With reference to figure 10a and to figure 10b that is a cross-section view of figure 10a in the plane (y,z) along the line C-C, second recesses are formed defining the cantilever structures 30 and 31 that partially surround the two sensor units 22 and 23, respectively. The surface area in a plane parallel to the plane (x,y) (i.e., to the upper surface of the substrate) of the second recesses 35 and 36 preferably has a U-shape and defines, the area of the structures 30 and 31, respectively, that will be arranged at a certain elevation angle, $\vartheta$, with respect to the substrate. The second recesses 35 and 36 are formed through photolithography and etching, for example through RIE, Reactive Ion Etching, which is stopped at a depth along the vertical axis corresponding to at least the surface of the substrate 10. In other words, the etching continues to a depth such as to completely remove the sacrificial layer 11 and uncover the substrate 10. Preferably, the second recesses partially surround the area of the first recesses 26 an 27. More preferably, the second recesses 35 and 36 extend in the direction of the LENGTH L1 to the edges of the respective first recesses 26 and 27. In this way, there is a lateral access point to the sacrificial layer around the structures 30 and 31 and to the recesses 26 and 27.

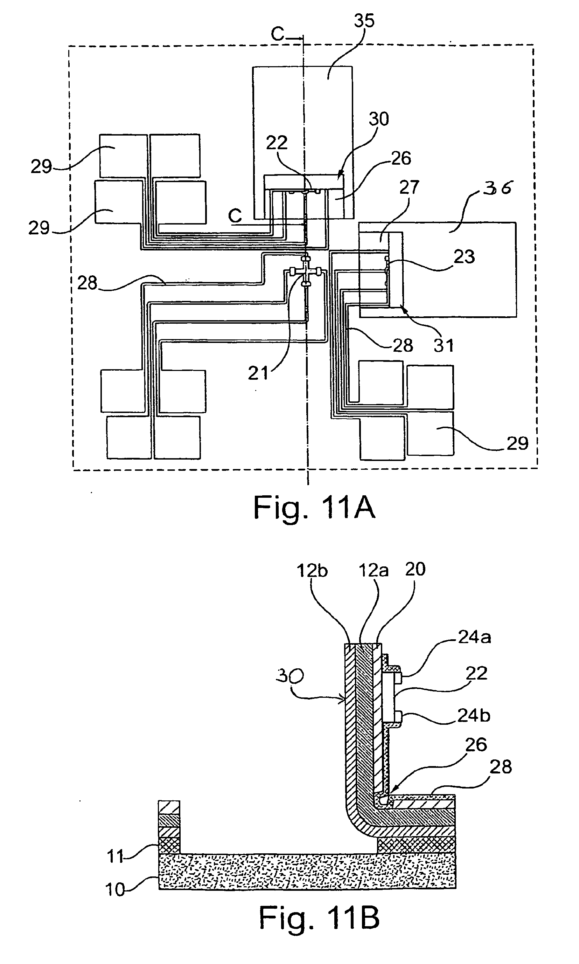

In a subsequent step, the sacrificial layer 11 beneath the strained structure 12 of the structures 30 and 31 and of the recesses 26 and 27 is removed, for example is dissolved through wet etching. The removal of the layer on which the strained structure 12 has been grown is accompanied by the release of the strain caused by the difference of lattice constant between the films that make up the strained structure. The release of the strain causes the hinge regions corresponding to the recesses 26 and 27 to curve and consequently causes the cantilever structures 30 and 31 to rise with respect to the substrate beneath, as illustrated in figures 11a and 11b.

In the case in which the strained structure 12 is made up of a bi-film $In_xGa_{(1-x)}As/GaAs$ and the substrate 10 is made up of GaAs, the lattice constant of $In_xGa_{(1-x)}As$ is greater than the lattice constant of GaAs, the difference between the atomic spacing of the two lattices depends upon x and is greatest for x=1 ($\Delta a/a$=7.2% between InAs and GaAs). Therefore, during the growth, the layer 12b of $In_xGa_{(1-x)}As$ elastically deforms by compression so as to adapt its lattice to that of the substrate, whereas the upper layer 12a of GaAs grown on it undergoes a tensile stress. The interatomic forces that act in the compressed film and in the elongated film respectively along opposite directions produce a moment of force that acts by curving the strained structure 12 in the surface area freed from the layer beneath it. Since also the structures 30 and 31 are arranged above an area free from the substrate beneath and are attached to the region of the strained structure 12 free from the layers beneath, the curving of the bi-film in the regions corresponding to the recesses 26 and 27, i.e. to the hinge structures formed by the strained structure, thus leads to the release of the structures 30 and 31, which become cantilever structures. As an example, for the removal of the sacrificial AlAs layer, the structure is immersed in a bath of $HF:H_2O$ 1:5 that dissolves the AlAs without significantly etching the bi-film $In_xGa_{(1-x)}As/GaAs$ or the heterostructure of GaAs and ternary alloys based upon GaAs. For example, the layer of AlAs has a thickness of at least 50 nm and ranges between 50 and 100 nm so as to ensure an even penetration of the etching solution from the vertical walls along the layer, i.e. along the plane (x,y).

The released structure is arranged at an elevation angle $\vartheta$, that depends on the length L2 of the hinge region, indicated in figure 7a, and on the radius of curvature of the strained structure, $\rho$, according to the relationship

$$\vartheta = \frac{L2}{\rho}. \qquad (3)$$

The radius of curvature $\rho$ depends upon parameters of the strained structure 12, like the thickness and the composition of the epitaxial film forming the strained structure. In some preferred embodiments, the parameters of the strained structure are suitably designed so as to obtain an elevation angle of 90°. For example, to obtain the verticality of the planes on which the out-of-plane sensor units are, the following parameters are selected: 10nm of $In_{0.2}Ga_{0.8}As$ (film 12b) and 265nm of GaAs (film 12a), and L2=155 $\mu$m.

Although the embodiment in which the two out-of-plane sensor units are arranged in planes substantially perpendicular to the plane of the third sensor unit is preferred since it makes it possible to detect the three axial components of the magnetic field in an independent manner, the present invention also covers a triaxial sensor device in which the two out-of-plane sensor units are arranged at different angles from 90° and/or different from one another. In one embodiment, the elevation angle of each out-of-plane sensor unit is greater than 0° and less or equal to 90°.

Figure 12 schematically and partially illustrates a triaxial sensor device, in which the two out-of-plane sensor units 302 and 303 are arranged at respective angles $\alpha$ and $\beta$ with respect to the plane (x,y) of the third sensor unit 301. In particular, the plane on which the sensor unit 302 is arranged is parallel to the axis x and is inclined with respect to the axis y of the angle $\alpha$ and the plane on which the sensor unit 303 is arranged is parallel to the axis y and is inclined with respect to the axis x of the angle $\beta$. Therefore, the versors perpendicular to the three planes are:

$$\vec{n}_I = \left(0,0,1\right)$$

$$\vec{n}_{II} = \left(0, \sin\alpha, \cos\alpha\right) \qquad (4)$$

$$\vec{n}_{III} = \left(\sin\beta, 0, \cos\beta\right)$$

where $n_I$ is the versor perpendicular to the plane of the sensor unit 301, $n_{II}$ is the versor perpendicular to the plane of the sensor unit 302, and $n_{III}$ is the versor perpendicular to the plane of the sensor unit 303.

Assuming that the sensor device is immersed in a homogeneous generically oriented magnetic field, $\vec{B}=(B_x, B_y, B_z)$, and that each sensor unit 301, 302 and 303 is sensitive only to the component of the magnetic field perpendicular to its own plane, indicated with $B_i$, for i=I,II,III. The following relationships apply:

$$B_I = \vec{B}\cdot\vec{n}_I = B_z$$

$$B_{II} = \vec{B}\cdot\vec{n}_{II} = B_y\sin\alpha + B_z\cos\alpha \qquad (5)$$

$$B_{III} = \vec{B}\cdot\vec{n}_{III} = B_x\sin\beta + B_z\cos\beta$$

in which it can be seen that the sensor unit 301 directly detects the component $B_z$. From the reading of the other two sensor units and knowing the angles $\alpha$ and $\beta$, it is possible to work out the other two components $B_x$ and $B_y$.

The device made with the process described above does not require any assembly of parts and thanks to the engineering of both the heterostructures and of the manufacturing processes by using lithographic techniques, techniques for depositing thin films and chemical etching, it can be made with small sizes, obtaining high spatial resolution. In other words, the minimum dimensions of the sensor device mainly depends upon the resolution of the manufacturing micro- and nano-technology techniques.

**Claims**

1.   An integrated triaxial magnetic sensor device (100) apt to detect a magnetic field comprising

- a substrate (120) having a surface defining a reference plane;
- a first sensor unit (101) arranged on the substrate on a first main surface (121) in a first plane substantially parallel to the reference plane;
- a second sensor unit (102) arranged on a second plane, and
- a third sensor unit (103) arranged on a third plane, the second and third plane being not parallel to the reference plane,

**characterised by** further comprising:

- a first cantilever structure (115) raised with respect to the reference plane of a first elevation angle ($\vartheta;\alpha$) and having a second main surface (125) arranged along the second plane, the first cantilever structure including the second sensor unit, and
- a second cantilever structure (116) raised with respect to the reference plane of a second elevation angle ($\vartheta; \beta$) and having a third main surface (126) arranged along the third plane, the second cantilever structure including the third sensor unit,

wherein the first and the second cantilever structure are structurally connected to the substrate (120) through a respective first and second hinge structure (113, 114) curved with respect to the reference plane and bearing the respective cantilever structure while maintaining it raised with respect to the reference plane, the first and second hinge structures have a thickness smaller than the thickness of the respective first and second cantilever structures and

first and second recesses (26, 27) having a surface and defining the first and second hinge structures, the recesses having connecting walls defining the recesses and being inclined by a predetermined inclination angle ($\gamma$) with respect to the surface of the recess.

2. The device according to claim 1, wherein the first ($\theta;\alpha$) and the second ($\theta;\beta$) elevation angle are of about 90˚.

3. The device according to claim 1 or 2, wherein:

   the first hinge structure (113) has a first upper surface and the second hinge structure (114) has a second upper surface, the first and the second hinge structure having a respective first thickness,
   the first cantilever structure (115) and the second cantilever structure (116) have a respective second thickness larger than the thickness of the respective hinge structure so as to define a respective first connecting wall between the first upper surface and the second main surface (125) of the first cantilever structure and a second connecting wall between the second upper surface and the third main surface (126) of the second cantilever structure.

4. The device according to claim 1, wherein the inclination angle ($\gamma$) of the first recess (26) is of from 10˚ to 70˚.

5. The device according to claims 3 or 4, wherein:

   the first hinge structure (113) is connected to the substrate (120) along a first connecting line (117) defined on the first main surface (121) and is arranged recessed relative to said first main surface, the first upper surface of the first hinge structure being connected to the first main surface by a third connecting wall, and
   the second hinge structure (114) is connected to the substrate along a second connecting line (118) defined on the first main surface and is arranged recessed relative to said first main surface, the second upper surface of the second hinge structure being connected to the main surface by a fourth connecting wall.

6. The device according to claim 6, wherein the third and the fourth connecting wall are inclined with respect to the respective first and second upper surface by a respective second inclination angle.

7. The device according to any one of the previous claims, wherein each of the first and second hinge structure (113, 114) comprises a strained structure comprising a plurality of semiconductor layers having respectively different lattice constants, wherein the curvature of each hinge structure is due to the strain release caused by the difference in the lattice constants.

8. The device according to claim 7, wherein each of the first and second hinge structure comprises a first semiconducting layer having a first lattice constant and a second semiconducting layer having a second lattice constant, the first semiconducting layer being arranged on the second semiconducting layer and the first lattice constant being smaller than the second lattice constant.

9. The device according to claims 7 or 8, wherein the first and the second hinge structure (113, 114) have a respective lower surface opposite to the respective upper surface and the first and the second cantilever structure (115, 116) comprise a respective lower surface opposite to the main surface on which the respective second and third sensor unit are arranged, and wherein each of the first and second cantilever structure comprises a heterostructure arranged on a strained structure, the strained structure included in the respective cantilever structure being identical to the strained structure of the respective hinge structure and the lower surface of the first and second cantilever structure being continuously connected with the lower surface of the respective hinge structure.

10. The device according to any one of the previous claims, wherein the first, the second and the third sensor unit are Hall sensors comprising a respective first, second and third heterostructure, each made up of a plurality of semiconductor layers sequentially arranged along the vertical direction with respect to the respective first, second and third plane, at least one of the plurality of semiconductor layers being a magneto-sensitive layer.

11. The device according to claim 10, wherein the magneto-sensitive layer includes the formation of a two-dimensional electron gas 2DEG.

12. The device according to claims 10 or 11, wherein each heterostructure comprises an embossed mesa structure apt to define the magnetic field detection area of the respective sensor unit, the mesa structure vertically extending for at least a first vertical portion of the heterostructure.

13. The device according to claim 12, wherein the mesa structure of each heterostructure extends for the first vertical portion, the first vertical portion being arranged on a second vertical portion of the heterostructure having as upper surface on which the mesa structure is defined the respective main surface, and wherein the first vertical portion extends to a predetermined depth located, along the vertical direction, in the proximity of the magneto-sensitive layer so as to define a residual thickness (r) between the upper interface of the magneto-sensitive layer and the respective upper surface of the second vertical portion.

14. The device according to claim 13, wherein the residual thickness is of from 3 nm to 20 nm.

15. The device according to claims 13 or 14, wherein each heterostructure comprises a buffer layer, a spacer layer arranged on the buffer layer, a channel layer arranged on the spacer layer and forming an interface with it and a barrier layer arranged on the channel layer, the magneto-sensitive layer forming in the channel layer in the proximity of the interface with the spacer layer, and wherein the first vertical portion of the mesa structure of each heterostructure extends vertically from the respective main surface to the spacer layer and including at least a vertical portion of the same.

**Patentansprüche**

1. Integrierte dreiachsige Magnetsensor-Vorrichtung (100), die geeignet ist, ein magnetisches Feld festzustellen, umfassend:

   - ein Substrat (120), das eine Oberfläche hat, die eine Referenzebene definiert,
   - eine erste Sensoreinheit (101), die auf dem Substrat auf einer ersten Hauptfläche (121) in einer ersten Ebene im Wesentlichen parallel zur Referenzebene angeordnet ist,
   - eine zweite Sensoreinheit (102), die in einer zweiten Ebene angeordnet ist, und
   - eine dritte Sensoreinheit (103), die in einer dritten Ebene angeordnet ist, wobei die zweite und dritte Ebene nicht parallel zur Referenzebene sind,

   **dadurch gekennzeichnet, daß** sie ferner umfaßt:

   - eine erste Konsolenstruktur (115), die bezüglich der Referenzebene um einen ersten Erhebungswinkel ($\theta$; $\alpha$) angehoben ist und eine zweite Hauptfläche (125) hat, die entlang der zweiten Ebene angeordnet ist, wobei die erste Konsolenstruktur die zweite Sensoreinheit umfaßt, und
   - eine zweite Konsolenstruktur (116), die bezüglich der Referenzebene um einen zweiten Erhebungswinkel ($\theta$; $\beta$) angehoben ist und eine dritte Hauptfläche (126) hat, die entlang der dritten Ebene angeordnet ist, wobei die zweite Konsolenstruktur die dritte Sensoreinheit umfaßt,

   wobei die erste und die zweite Konsolenstruktur strukturell mit dem Substrat (120) durch eine jeweilige erste und zweite Scharnierstruktur (113, 114) verbunden sind, die bezüglich der Referenzebene gekrümmt ist und die jeweilige Konsolenstruktur trägt, während sie diese bezüglich der Referenzebene aufrechterhält, die erste und zweite Scharnierstruktur eine Dicke haben, die geringer als die Dicke der jeweiligen ersten und zweiten Konsolenstruktur sind, und erste und zweite Vertiefungen (26, 27), die eine Oberfläche haben und die erste und zweite Scharnierstruktur definieren, wobei die Vertiefungen Verbindungswände haben, die die Vertiefungen definieren und die um einen vorgegebenen Neigungswinkel ($\gamma$) gegenüber der Oberfläche der Vertiefung geneigt sind.

2. Vorrichtung nach Anspruch 1, wobei der erste ($\theta$; $\alpha$) und zweite ($\theta$; $\beta$) Neigungswinkel etwa 90˚ betragen.

3. Vorrichtung nach Anspruch 1 oder 2, wobei:

   die erste Scharnierstruktur (113) eine erste obere Fläche und die zweite Scharnierstruktur (114) eine zweite obere Fläche hat, wobei die erste und zweite Scharnierstruktur eine jeweilige erste Dicke haben,
   die erste Konsolenstruktur (115) und die zweite Konsolenstruktur (116) eine jeweilige zweite Dicke haben, die größer als die Dicke der jeweiligen Scharnierstruktur ist, um so eine jeweilige erste Verbindungswand zwischen der ersten oberen Fläche und der zweiten Hauptfläche (125) der ersten Konsolenstruktur zu definieren und eine zweite Verbindungswand zwischen der zweiten oberen Fläche und der dritten Hauptfläche (126) der zweiten Konsolenstruktur zu definieren.

4. Vorrichtung nach Anspruch 1, wobei der Neigungswinkel ($\gamma$) der ersten Vertiefung (26) im Bereich von 10˚ bis 70˚ liegt.

5. Vorrichtung nach Anspruch 3 oder 4, wobei:

die erste Scharnierstruktur (113) mit dem Substrat (120) entlang einer ersten Verbindungslinie (117) verbunden ist, die auf der ersten Hauptfläche (121) definiert ist und vertieft gegenüber der ersten Hauptfläche angeordnet ist, wobei die erste obere Fläche der ersten Scharnierstruktur mit der ersten Hauptfläche durch eine dritte Verbindungswand verbunden ist, und
die zweite Scharnierstruktur (114) mit dem Substrat entlang einer zweiten Verbindungslinie (118) verbunden ist, die auf der ersten Hauptfläche definiert ist und vertieft gegenüber der ersten Hauptfläche angeordnet ist, wobei die zweite obere Fläche der zweiten Scharnierstruktur mit der Hauptfläche durch eine vierte Verbindungswand verbunden ist.

6. Vorrichtung nach Anspruch 5, wobei die dritte und die vierte Verbindungswand gegenüber der jeweiligen ersten und zweiten oberen Fläche um einen jeweiligen zweiten Neigungswinkel geneigt sind.

7. Vorrichtung nach einem der vorherigen Ansprüche, wobei jede der ersten und zweiten Scharnierstruktur (113, 114) eine gespannte Struktur umfaßt, die mehrere Halbleiterschichten umfaßt, welche jeweils unterschiedliche Gitterkonstanten haben, wobei die Krümmung jeder Scharnierstruktur auf die Entlastung zurückzuführen ist, die durch den Unterschied in den Gitterkonstanten verursacht ist.

8. Vorrichtung nach Anspruch 7, wobei jede der ersten und zweiten Scharnierstrukturen eine erste halbleitende Schicht umfaßt, die eine erste Gitterkonstante hat, und eine zweite halbleitende Schicht umfaßt, die eine zweite Gitterkonstante hat, wobei die erste halbleitende Schicht auf der zweiten halbleitenden Schicht angeordnet ist und die erste Gitterkonstante kleiner als die zweite Gitterkonstante ist.

9. Vorrichtung nach Anspruch 7 oder 8, wobei die erste und die zweite Scharnierstruktur (113, 114) eine jeweilige untere Fläche gegenüber der jeweiligen oberen Fläche haben und die erste und die zweite Konsolenstruktur (115, 116) eine jeweilige untere Fläche gegenüber der Hauptfläche haben, auf der die jeweilige zweite und dritte Sensoreinheit angeordnet sind, und wobei jede der ersten und zweiten Konsolenstrukturen eine Heterostruktur umfaßt, die auf einer gespannten Struktur angeordnet ist, wobei die in der jeweiligen Konsolenstruktur enthaltene gespannte Struktur identisch mit der gespannten Struktur der jeweiligen Scharnierstruktur ist, und die untere Fläche der ersten und zweiten Konsolenstruktur durchgängig mit der unteren Fläche der jeweiligen Scharnierstruktur verbunden ist.

10. Vorrichtung nach einem der vorherigen Ansprüche, wobei die erste, die zweite und die dritte Sensoreinheit Hall-Sensoren sind, die eine jeweilige erste, zweite und dritte Heterostruktur umfassen, wobei jede aus mehreren Halbleiterschichten besteht, die nacheinander entlang der vertikalen Richtung in Bezug auf die erste, zweite und dritte Ebene angeordnet sind, wobei mindestens eine der mehreren Halbleiterschichten eine magnetisch empfindliche Schicht ist.

11. Vorrichtung nach Anspruch 10, wobei die magnetisch empfindliche Schicht die Bildung eines zweidimensionalen Elektronengases 2DEG umfaßt.

12. Vorrichtung nach Anspruch 10 oder 11, wobei jede Heterostruktur eine erhabene Mesa-Struktur umfaßt, die geeignet ist, den Feststellungsbereich eines Magnetfeldes der jeweiligen Sensoreinheit zu definieren, wobei sich die Mesa-Struktur vertikal zumindest über einen ersten vertikalen Abschnitt der Heterostruktur erstreckt.

13. Vorrichtung nach Anspruch 12, wobei die Mesa-Struktur jeder Heterostruktur sich über den ersten vertikalen Abschnitt erstreckt, wobei der erste vertikale Abschnitt auf einem zweiten vertikalen Abschnitt der Heterostruktur angeordnet ist, die eine obere Fläche hat, auf der die Mesa-Struktur durch die jeweilige Hauptfläche definiert ist, und wobei der erste vertikale Abschnitt sich bis zu einer vorgegebenen Tiefe erstreckt, die sich entlang der vertikalen Richtung in der Nähe der magnetisch empfindlichen Schicht befindet, um so eine Restdicke (r) zwischen der oberen Grenzfläche der magnetisch empfindlichen Schicht und der jeweiligen oberen Fläche des zweiten vertikalen Abschnitts zu definieren.

**14.** Vorrichtung nach Anspruch 13, wobei die Restdicke 3 nm bis 20 nm beträgt.

**15.** Vorrichtung nach Anspruch 13 oder 14, wobei jede Heterostruktur eine Pufferschicht, eine Abstandsschicht, die auf der Pufferschicht angeordnet ist, eine Kanalschicht, die auf der Abstandsschicht angeordnet ist und eine Grenzfläche damit bildet, und eine Sperrschicht umfaßt, die auf der Kanalschicht angeordnet ist, wobei die magnetisch empfindliche Schicht sich in der Kanalschicht in der Nähe der Grenzfläche mit der Abstandsschicht bildet, und wobei der erste vertikale Abschnitt der Mesa-Struktur jeder Heterostruktur sich vertikal von der jeweiligen Hauptfläche aus zur Abstandsschicht erstreckt und mindestens einen vertikalen Abschnitt derselben umfaßt.

**Revendications**

**1.** Dispositif intégré à capteur magnétique triaxial (100) apte à détecter un champ magnétique, comprenant:

- un substrat (120) ayant une surface qui définit un plan de référence,
- une première unité capteur (101) disposée sur ledit substrat sur une première surface principale (121) dans un premier plan pour l'essentiel parallèle au plan de référence,
- une deuxième unité capteur (102) disposée dans un deuxième plan, et
- une troisième unité capteur (103) disposée dans un troisième plan, lesdits deuxième et troisième plans n'étant pas parallèles au plan de référence,

**caractérisé par le fait qu'**il comprend en outre:

- une première structure en console (115) qui est relevée d'un premier angle d'élévation ($\theta$; $\alpha$) par rapport au plan de référence et qui présente une deuxième surface principale (125) agencée le long du deuxième plan, ladite première structure en console intégrant ladite deuxième unité capteur, et
- une deuxième structure en console (116) qui est relevée d'un deuxième angle d'élévation ($\theta$; $\beta$) par rapport au plan de référence et qui présente une troisième surface principale (126) agencée le long du troisième plan, ladite deuxième structure en console intégrant ladite troisième unité capteur,

lesdites première et deuxième structures en console étant reliées structurellement au substrat (120) par une première et une deuxième structure en charnière (113, 114) respective qui est courbée par rapport au plan de référence et porte la structure en console respective tout en la maintenant relevée par rapport au plan de référence, lesdites première et deuxième structures à charnière présentent une épaisseur qui est inférieure à l'épaisseur des première et deuxième structures respectives en console, et des premier et deuxième creux (26, 27) qui présentent une surface et définissent lesdites première et deuxième structures à charnière, lesdits creux ayant des parois de liaison qui définissent lesdits creux et sont inclinées d'un angle d'inclinaison ($\gamma$) prédéterminé par rapport à la surface du creux.

**2.** Dispositif selon la revendication 1, dans lequel les premier ($\theta$; $\alpha$) et deuxième ($\theta$; $\beta$) angles d'inclinaison sont de 90˚ à peu près.

**3.** Dispositif selon la revendication 1 ou 2, dans lequel:

la première structure à charnière (113) présente une première surface supérieure et la deuxième structure à charnière (114) présente une deuxième surface supérieure, lesdites première et deuxième structures à charnière ayant une première épaisseur respective, ladite première structure en console (115) et ladite deuxième structure en console (116) présentent une deuxième épaisseur respective qui est supérieure à l'épaisseur de la structure respective à charnière afin de définir ainsi une première paroi respective de liaison entre la première surface supérieure et la deuxième surface principale (125) de la première structure en console ainsi qu'une deuxième paroi de liaison entre la deuxième surface supérieure et la troisième surface principale (126) de la deuxième structure en console.

**4.** Dispositif selon la revendication 1, dans lequel l'angle d'inclinaison ($\gamma$) du premier creux (26) est compris entre 10˚ et 70 ˚.

**5.** Dispositif selon la revendication 3 ou 4, dans lequel:

**17**

la première structure à charnière (113) est reliée au substrat (120) suivant une première ligne de jonction (117) qui est définie sur la première surface principale (121) et est disposée en retrait par rapport à ladite première surface principale, la première surface supérieure de la première structure à charnière étant reliée à ladite première surface principale par une troisième paroi de liaison, et

la deuxième structure à charnière (114) est reliée au substrat suivant une deuxième ligne de jonction (118) qui est définie sur la première surface principale et est disposée en retrait par rapport à ladite première surface principale, la deuxième surface supérieure de la deuxième structure à charnière étant reliée à ladite surface principale par une quatrième paroi de liaison

6. Dispositif selon la revendication 5, dans lequel lesdites troisième et quatrième parois de liaison sont inclinées d'un deuxième angle d'inclinaison respectif par rapport à la première et à la deuxième surfaces supérieures respectives.

7. Dispositif selon l'une quelconque des revendications précédentes, dans lequel chacune des première et deuxième structures à charnière (113, 114) comprend une structure contrainte comprenant une pluralité de couches semi-conductrices ayant respectivement des constantes de réseau différentes, la courbure de chaque structure à charnière étant due au relâchement causé par la différence dans les constantes de réseau.

8. Dispositif selon la revendication 7, dans lequel chacune des première et deuxième structures à charnière comprend une première couche semi-conductrice ayant une première constante de réseau, ainsi qu'une deuxième couche semi-conductrice ayant une deuxième constante de réseau, ladite première couche semi-conductrice étant disposée sur ladite deuxième couche semi-conductrice et la première constante de réseau étant inférieure à la deuxième constante de réseau.

9. Dispositif selon la revendication 7 ou 8, dans lequel les première et deuxième structures à charnière (113, 114) présentent une surface inférieure respective opposée à la surface supérieure respective et les première et deuxième structures en console (115, 116) présentent une surface inférieure respective opposée à la surface principale sur laquelle sont disposées les deuxième et troisième unités capteurs respectives, et dans lequel chacune des première et deuxième structures en console comprend une hétérostructure disposée sur une structure contrainte, la structure contrainte comprise dans la structure respective en console étant identique à la structure contrainte de la structure respective à charnière, et la surface inférieure des première et deuxième structures en console étant reliée de manière continue à la surface inférieure de la structure respective à charnière.

10. Dispositif selon l'une quelconque des revendications précédentes, dans lequel les première, deuxième et troisième unités capteurs sont des capteurs à effet Hall qui comprennent des première, deuxième et troisième hétérostructures respectives, chacune étant constituée par une pluralité de couches semi-conductrices disposées successivement suivant la direction verticale par rapport aux premier, deuxième et troisième plans, l'une au moins de la pluralité des couches semi-conductrices étant une couche magnétiquement sensible.

11. Dispositif selon la revendication 10, dans lequel ladite couche magnétiquement sensible comprend la formation d'un gaz d'électrons à deux dimensions GE2D.

12. Dispositif selon la revendication 10 ou 11, dans lequel chaque hétérostructure comprend une structure mesa en relief apte à définir la zone de détection de champ magnétique de l'unité capteur respective, ladite structure mesa s'étendant verticalement au moins sur une première portion verticale de ladite hétérostructure.

13. Dispositif selon la revendication 12, dans lequel ladite structure mesa de chaque hétérostructure s'étend sur la première portion verticale, ladite première portion verticale étant disposée sur une deuxième portion verticale de ladite hétérostructure ayant une surface supérieure sur laquelle la structure mesa est définie par la surface principale respective, et dans lequel la première portion verticale s'étend jusqu'à une profondeur prédéterminée située, suivant la direction verticale, à proximité de ladite couche magnétiquement sensible afin de définir ainsi une épaisseur résiduelle (r) entre l'interface supérieure de la couche magnétiquement sensible et la surface supérieure respective de la deuxième portion verticale.

14. Dispositif selon la revendication 13, dans lequel ladite épaisseur résiduelle est comprise entre 3 nm et 20 nm.

15. Dispositif selon la revendication 13 ou 14, dans lequel chaque hétérostructure comprend une couche tampon, une couche d'écartement disposée sur ladite couche tampon, une couche de canal disposée sur ladite couche d'écartement et formant une interface avec celle-ci, ainsi qu'une couche de blocage disposée sur ladite couche de canal, la couche magnétiquement sensible étant formée dans ladite couche de canal à proximité de ladite interface avec la couche d'écartement, et dans lequel la première portion verticale de la structure mesa de chaque hétérostructure s'étend verticalement depuis la surface principale respective vers la couche d'écartement et comprend au moins une portion verticale de celle-ci.

Fig. 1

EP 2 261 684 B1

Fig. 2a

Fig. 2b

11

10

Fig. 3

12a

12 { 12b

11

10

Fig. 4

13

A

A

x

y

Fig. 5a

Fig. 5b

Fig. 5c

Fig. 6a

Fig. 6b

Fig. 7a

Fig. 7b

Fig. 8a

Fig. 8b

Fig. 9a

24b   24a        28

20

12
11
10

Fig. 9b

35  28      22  24a
          C
24b              28

29                        30
26

                          28

                  31
          27                      36

28

                                  23

21                    29

28              29

34                          29

Fig. 10a

32

3.5  24b  24a    26    28

20

12
11
10

Fig. 10b

35

C

22　30　26

29　27　36

29

28　23

28　31

21

29

## Fig. 11A

12b　12a　20

24a

30　22

24b

26

28

11

10

## Fig. 11B

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070035294 A
- US 20080217288 A
- US 20020056202 A
- WO 9602848 A
- US 5672967 A
- US 20080169807 A
- US 20090058411 A

**Non-patent literature cited in the description**

- **M. Morvic ; J. Betko.** Planar effect in Hall sensors made from InP/InGaAs heterostructures. *Sensors and Actuators A,* 2005, vol. 120, 130-133
- **N. Haned ; M. Missous.** Nano-tesla magnetic field magnetometry using an InGaAs-AlGaAs-GaAs 2DEG Hall sensor. *Sensors and Actuators A,* 2003, vol. 102, 216-222
- **D.R. Popovic et al.** Three-axis Teslameter With Integrated Hall Probe. *IEEE Transactions on Instrumentation and Measurement,* 2007, vol. 56 (4), 1396-1402
- **P. Kejik et al.** First fully CMOS-integrated 3D Hall probe", published in "proceedings. *13th International conference on Solid-State Sensors, Actuators and Microsystems,* 2005, vol. 1, 317-320
- **V. Ya. Prinz.** A new concept in fabricating building blocks for nanoelectronic and nanomechanic devices. *Microelectronic Engineering,* 2003, vol. 69, 466-475
- **S. Iida ; K. Ito.** Selective Etching of Gallium Arsenide Crystals in H2SO4-H2O2-H2O System. *Journal of Electrochemical Society,* 1971, vol. 118-5, 768